# EUROPÄISCHE PATENTSCHRIFT

(11) **EP 1 166 165 B1**
(45) Veröffentlichungstag und Bekanntmachung des Hinweises auf die Patenterteilung: **11.09.2002**
(21) Anmeldenummer: 00912651.7
(22) Anmeldetag: 28.03.2000
(51) Int. Cl.: G02B 27/09, G02B 6/42, H01S 5/40, H01S 3/00, H01S 3/0941

(54) **OPTISCHE ANORDNUNG ZUR SYMMETRIERUNG DER STRAHLUNG VON ZWEIDIMENSIONALEN ARRAYS VON LASERDIODEN**
OPTICAL ARRANGEMENT FOR SYMMETRIZING THE RADIATION OF TWO-DIMENSIONAL ARRAYS OF LASER DIODES
DISPOSITIF OPTIQUE POUR RENDRE SYMETRIQUES LES RAYONNEMENTS DE RESEAUX BIDIMENSIONNELS DE DIODES LASER

(30) Priorität: 31.03.1999 DE 19914755
(43) Veröffentlichungstag der Anmeldung: 02.01.2002
(73) Patentinhaber: FRAUNHOFER-GESELLSCHAFT ZUR FÖRDERUNG DER ANGEWANDTEN FORSCHUNG E.V., 80636 München (DE)
(72) Erfinder: GÖRING, Rolf, D-07749 Jena (DE); POSSNER, Torsten, D-07747 Jena (DE); SCHREIBER, Peter, D-07749 Jena (DE)
(86) Internationale Anmeldenummer: EP0002708
(87) Internationale Veröffentlichungsnummer: WO00060399

(56) Entgegenhaltungen:
- WO-A-96/21877
- DE-A- 19 645 150
- GOERING R ET AL: "MICROOPTICAL BEAM TRANSFORMATION SYSTEM FOR HIGH-POWER LASER DIODE BARS WITH EFFICIENT BRIGHTNESS CONSERVATION" PROCEEDINGS OF THE SPIE,US,SPIE, BELLINGHAM, VA, Bd. 3008, 10. Februar 1997 (1997-02-10), Seiten 202-210, XP002057348

## Beschreibung

Die Erfindung betrifft eine optische Anordnung zur Symmetrierung der Strahlung von Laserdioden nach dem Oberbegriff des Hauptanspruchs.

Zur Herstellung von Hochleistungslaserdiodenanordnungen werden eine Mehrzahl von Laserdioden in fester Zuordnung zu sogenannnten Laserdiodenbarren nebeneinander angeordnet. Derartige Barren erreichen optische Ausgangsleistungen bis etwa 40W und bestehen aus in einer Reihe angeordneten Einzelemittern mit typischen Abmessungen der strahlenden Fläche von 50µm x 1 µm bis 200µm x 1 µm, wobei die lineare Anordnung dieser Emitter stets in Richtung ihrer größten Ausdehnung erfolgt. Zur Erzielung noch höherer Leistungen stapelt man derartige Laserdiodenbarren in Richtung der kleinen Ausdehnung der Emitter zu sogenannten Laserdiodenstacks übereinander. Die Abstrahlung dieser Stacks ist extrem unsymmetrisch und durch die nichtstrahlenden Bereiche zwischen den Einzelemittern eines Barrens und der Barren untereinander von einer - verglichen mit den Einzelemittern - geringen Strahldichte.

Zur Erzielung eines symmetrischen Bündels mit möglichst hoher Strahldichte, wie es z.B. für die Materialbearbeitung oder zum Pumpen von Festkörperlasern benötigt wird, sind optische Systeme erforderlich, die einerseits eine Strahlsymmetrierung, als auch eine Ausblendung der nichtstrahlenden Bereiche zur Erhaltung der Strahldichte bewirken.

Es sind Anordnungen zur Symmetrierung von Laserdiodenstacks zur Einkopplung in Lichtleitfasern bzw. Fokussierung in einen Brennfleck bekannt. Je nach den Anforderungen hinsichtlich Symmetrierung und Strahldichte sind hier unterschiedliche Konzepte Stand der Technik.

Die Kopplung eines Stacks wird in DE 195 00 513 C1 beschrieben. Nachteilig ist hier der Mindestabstand zwischen den Einzelbarren von der dreifachen Dicke der Kollimationslinsen, was ggf. der Integration einer möglichst großen Zahl von Barren für eine gegebene Höhe entgegensteht.

Eine Anordnung nach DE 195 44 488 erlaubt zwar durch den Einsatz vieler Barren eine Skalierung zu sehr hohen Leistungen, aber die erzielte Strahldichte ist um mindestens eine Größenordnung geringer, als die fasergekoppelter Laserdiodenbarren, wie nach DE 44 38 368.

Es ist ferner eine optische Anordnung zur Symmetrierung der Strahlung einer Mehrzahl von in fester Zuordnung nebeneinander angeordneten Laserdioden bekannt (DE 196 45 150 A1). Die Symmetrierungsanordnung besteht dabei aus einer um die optische Achse gedrehten Zylinderlinse, einer Direktionsoptik zur Ablenkung der Strahlenbündel der einzelnen Laserdioden, einer Redirektionsoptik zur Kompensierung der Ablenkung der Direktionsoptik und einer nachfolgenden Kollimationsoptik.

Der Erfindung liegt die Aufgabe zugrunde, eine optische Anordnung zur Symmetrierung der Abstrahlung einer skalierbaren Zahl von Laserdiodenbarren zu schaffen, die aus vergleichsweise einfach herzustellenden mikrooptischen Komponenten besteht, einer kostengünstigen Miniaturisierung zugänglich ist und bei der die mit der Symmetrierung einhergehenden Strahlungsdichteeinbußen möglichst gering sind. Insbesondere soll eine Verbesserung der Strahldichte verglichen mit fasergekoppelten Laserdiodenbarren erreicht werden.

Diese Aufgabe wird erfindungsgemäß durch die kennzeichnenden Merkmale des Hauptanspruchs in Verbindung mit den Merkmalen des Oberbegriffs gelöst.

### Bevorzugte Ausführungsbeispiele sind Gegenstand der Unteransprüche 2 bis 15

Durch eine jedem Einzelbarren zugeordnete, um dessen optische Achse (z-Achse) geneigte Mikrozylinderlinse werden die Ausgangsbündel der Einzelemitter eines jeden Barrens in Richtung der Stapelung der Laserdiodenbarren kollimiert, unterschiedlich abgelenkt und so getrennt. Diese Ablenkung erfolgt so, dass die Bündelschwerpunkte übereinanderliegender Einzelemitter unterschiedlicher Barren in der gleichen Höhe in dieser Richtung auf ein Redirektioriselement in einem vorgegebenen Abstand auftreffen. Ein den Mikrozylinderlinsen nachgeschaltetes Direktionselement bewirkt eine Umlenkung der Abstrahlung der Einzelemitter eines Barrens in der Richtung der linearen Anordnung der Einzelemitter, so dass die Bündelschwerpunkte der Emitter eines Barrens in einem vorgegebenen Abstand auf dem Redirektionselement in dieser Richtung zusammenfallen. Außerdem lenkt das Direktionselement die Bündelschwerpunkte der einzelnen Barren in der Stapelrichtung so ab, dass alle Schwerpunkte in der Stapelrichtung ebenfalls auf dem Redirektionselement zusammenfallen. Das Redirektionselement lenkt die von den einzelnen Emittern stammenden Strahlungsbündel derart um, dass die von dem Direktionselement erzeugten Ablenkwinkel wieder kompensiert werden. Eine dem Redirektionselement benachbarte Abbildungsoptik bildet nun die Abstrahlung eines jeden Barren in einen - in einem vorgegebenen Abstand befindlichen - Strahlungsfleck ab. Diese Strahlungflecke werden in die dort befindlichen Stirnflächen der gespreizten Fasern eines Lichtleitfaserbündels eingekoppelt. Dieses Bündel bewirkt eine Umordnung der ursprünglich in Richtung der Stapelung der Barren übereinanderliegenden Strahlungflecke zu dem gewünschten, symmetrischen Gesamtbrennfleck am Bündelausgang.

Die so beschriebene Anordnung erlaubt durch die Mehrfachausnutzung des Direktionsund Redirektionselements und der Abbildungsoptik für alle Barren bei einer weitestgehenden Erhaltung der Strahldichte der Einzelemitter eine einfache und kostengünstige Symmetrierung der Strahlung von Laserdiodenstacks.

Ein Ausführungsbeispiel ist in der Zeichnung dargestellt und wird in der nachfolgenden Beschreibung näher erläutert. Es zeigen:
**Fig 1** die optische Anordnung zur Symmetrierung der Strahlung eines zweidimensionalen Arrays von Laserdioden unter Verwendung eines Faserbündels und
**Fig 2** die optische Anordnung zur Symmetrierung der Strahlung eines zweidimensionalen Arrays von Laserdioden unter Verwendung von zusätzlichen ablenkenden Elementen.

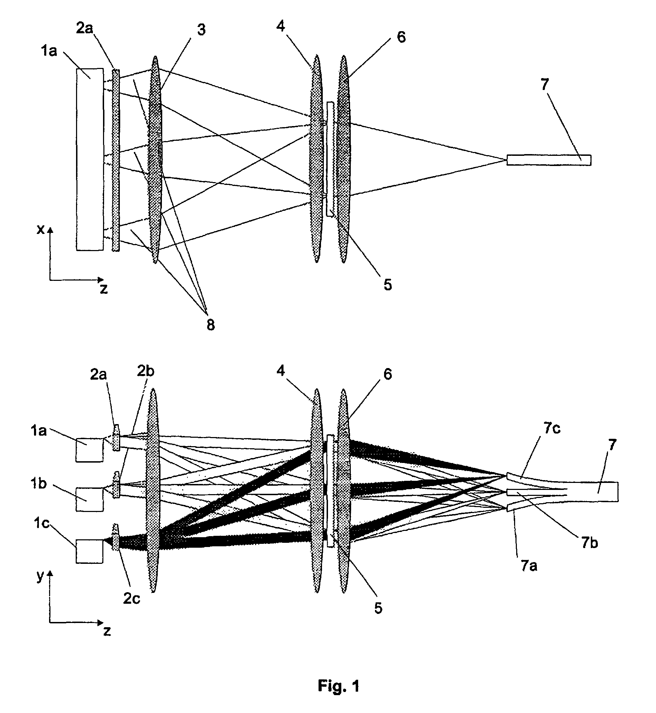

Bei der in **Fig. 1** dargestellten optischen Anordnung sind mit 1a, 1b, 1c drei in y-Richtung gestapelte Laserdiodenbarren bezeichnet, wobei die Beschränkung auf drei Barren 1a, 1b, 1c nur der besseren Veranschaulichung dient. Jeder dieser Barren 1a, 1b, 1c besteht aus einer Vielzahl von in x-Richtung angeordneten Einzelemittern - hier wurden der Übersichtlichkeit halber nur die zwei äußeren und der mittlere Emitter gezeichnet. Die Divergenz der Abstrahlung jedes Emitters ist in der yz-Ebene (fast axis) relativ groß, der halbe Öffnungswinkel beträgt 30° oder größer. In der xz-Ebene (slow axis) ist die Divergenz der Abstrahlung jedes Emitters dagegen vergleichsweise gering. Der halbe Öffnungswinkel beträgt dabei typischerweise etwa 6°. Die Gesamtausdehnung der Barren 1a, 1b, 1c beträgt in der slow axis typischerweise 10 mm. Der Stapelabstand der Barren 1a, 1b, 1c zueinander liegt im Bereich von ca. 0,1 mm bis einige Millimeter.

Den einzelnen Barren 1a, 1b, 1c nachgeordnet ist jeweils eine Mikrozylinderlinse 2a, 2b, 2c. Im Strahlengang befinden sich des weiteren in der Reihenfolge ein Direktionselement 3 und eine Linse 4, ein Redirektionselement 5, eine weitere Linse 6 sowie sich zu einem Lichtleitfaserbündel 7 vereinigende Lichtleitfasern 7a, 7b, 7c.

Die um die z-Achse verkippten Mikrozylinderlinsen 2a, 2b, 2c kollimieren die Abstrahlung der Einzelemitter und lenken die in der Zeichnung mit 8 bezeichneten Strahlenbündel der jeweils übereinanderliegenden Einzelemitter unterschiedlicher Barren 1a, 1b, 1c auf dieselbe Höhe auf dem Redirektionselement 5, so dass die Bündel 8 der Emitter eines Barrens 1a, 1b, 1c auf dem Redirektionselement 5 separiert sind. Als Mikrozylinderlinsen 2a, 2b, 2c kommen vorzugsweise gradientenoptische Zylinderlinsen oder Mehrkomponentenzylinderoptiken mit hinreichender Isoplanasie zum Einsatz. Typische Brennweiten der Mikrozylinderlinsen 2a, 2b, 2c liegen im Bereich von 100 µm bis ca. 1 mm.

Das Direktionselement 3 bewirkt eine Ablenkung der Einzelbündel 8 der Emitter in der slow axis und eine gleichartige Ablenkung der Bündel aller Emitter jedes einzelnen Barrens in der fast axis, so dass die Strahlenbündel 8 der Emitter eines Barrens 1a, 1b, 1c auf die gleiche x-Position und die Bündelschwerpunkte jedes Barrens auf die gleiche y-Position auf dem Redirektionselement 5 treffen.

Als Direktionselement 3 kommen Plan- oder Bikonvexlinsen oder Dubletts, vorzugsweise mit großem Feldwinkel, mit sphärischen oder ashärischen Flächen zum Einsatz.

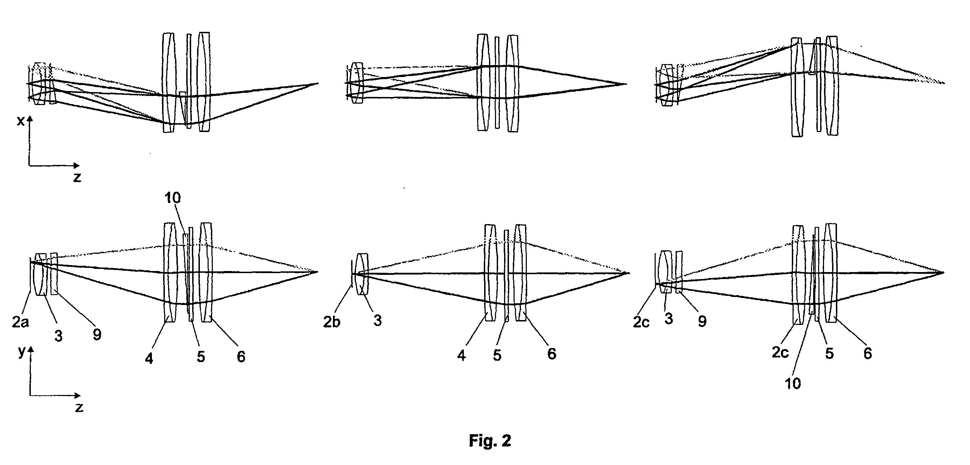

Eine mögliche andere Realisierung sind Kombinationen dieser Direktionslinse 3 mit Prismenarrays 9 gemäß **Fig. 2**, die einen Versatz der Strahlenbündel 8 der einzelnen Barren 1a, 1b, 1c auf dem Redirektionselement 5 in der slow axis bewirken. Hierbei wird jedem Barren 1a, 1b, 1c ein Prisma 9a, 9b, 9c, welches in der slow axis ablenkt, zugeordnet. Durch die so erreichte Separation der Bündelschwerpunkte der einzelnen Barren 1a, 1b, 1c auf dem Redirektionselement 5, ist- ein entsprechend ausgebildetes Redirektionselement 5 vorausgesetzt - eine Positionierung des Brennflecks für jeden Barren 1a, 1b, 1c in der y-Richtung einzeln realisierbar, z.B. können die einzelnen Brennflecke auch exakt aufeinander positioniert werden. Die Kombination von Direktionslinse 3 und Prismenarray 9 kann alternativ auch durch eine Zerlegung der Direktionslinse 3 in mehrere Segmente, die in der slow axis zueinander versetzt angeordnet sind, erzielt werden. Die Brennweiten des Direktionselements 3 liegen typischerweise im Bereich einiger mm bis einiger 10 mm.

Dem Direktionselement 3 nachgeschaltet ist das Redirektionselement 5 (siehe **Fig. 1**) und die Abbildungsoptik 4, 6. In der konkreten Realisierung folgt zunächst die Linse 4, deren Brennweite der Direktorbrennweite entspricht. Diese erste Linse 4 der Abbildungoptik bewirkt eine Kollimation der Strahlenbündel der Einzelemitter in der slow axis. Das ermöglicht eine nahezu aberrationsfreie Arbeitsweise des Redirektionselements 5. Die Ausführungsmöglichkeiten für die erste Linse 4 der Abbildungsoptik entsprechen den Varianten für das Direktionselement 3.

Das Redirektionselement 5 besteht aus einer Anzahl in der fast axis gestapelter Elemente mit ablenkender Wirkung in der slow axis, z.B. ein Array geblazter Gitter, ein Prismenstapel oder einem Spiegelarray. Nach dem Redirektionselement 5 erhält man von jedem Barren 1a, 1b, 1c ein kollimiertes Strahlenbündel mit rechteckigem oder quadratischem Querschnitt. Die Abstrahlrichtung dieser kollimierten Strahlenbündel vom Redirektionselement 5 ist für jeden Barren 1a, 1b, 1c in der fast axis unterschiedlich.

Wird gemäß **Fig. 2** durch eine Kombination von Direktionslinse 3 und Prismenarray 9 eine Separation der Strahlenbündel 8 der einzelnen Barren 1a, 1b, 1c in der slow axis auf dem Redirektionselement 5 erzielt, können diese unterschiedlichen Abstrahlrichtungen durch geeignete, in der fast und slow axis ablenkende Elemente 10 in der Nähe des Redirektionselements 5 kompensiert werden. Diese Elemente 10 sind z. B. durch zusätzliche Prismen in der Nähe des Redirektionselements 5, durch eine geeignete Ausbildung des Redirektionselements 5, z.B. als Array von zweidimensional ablenkenden, geblazten Gittern, oder Kombinationen dieser Elemente realisierbar. Nach dem Redirektionselement 5 liegt somit ein weitgehend symmetriertes, kollimiertes Strahlenbündel mit hoher Strahldichte vor. Für Anwendungen, bei denen ein kollimiertes Strahlenbündel mit rechteckigem Querschnitt benötigt wird, kann auf die sonst folgende zweite Linse 6 der Abbildungsoptik verzichtet werden.

Üblicherweise wird aber ein fokussiertes Ausgangsbündel benötigt. Die nachfolgende Linse 6 bildet die Einzelemitter des jeweiligen Barrens 1a, 1b, 1c in einem gemeinsamen Brennfleck ab.

In **Fig. 1** dargestellt sind in der Fokalbebene der Linse 6 angeordnete Lichtleitfasern 7a, 7b, 7c, in die die überlagerten Abbilder der Emitter eines jeden Barrens 1a, 1b, 1c eingekoppelt werden. Durch die Vereinigung dieser Lichtleitfasern 7a, 7b, 7c zu einem Faserbündel 7 erzielt man den gewünschten, symmetrischen Bündelquerschnitt, bei weitestgehender Beibehaltung der Strahldichte.

Wird wie in Figur 2 dargestellt die Variante der Kombination der Direktorlinse 3 und des Redirektors 5 mit je einem Prismenarray 9 bzw. 10 verwirklicht, erzielt man einen gemeinsamen Brennfleck aller Barren 1a, 1b, 1c in der Fokalebene der Linse 6. Somit ist bei dieser Realisierung kein gespreiztes Faserbündel zur Zusammenführung der Brennflecke der einzelnen Barren 1a, 1b, 1c erforderlich.

## Patentansprüche

1. Optische Anordnung zur Symmetrierung der Strahlung einer Mehrzahl von in fester Zuordnung in der x-Richtung nebeneinander und in der dazu senkrechten y-Richtung übereinander angeordneter Laserdioden, deren jeweilige
Ausgangsstrahlung in bezug auf die y-Richtung und die x-Richtung unsymmetrisch ist, insbesondere zur Symmetrierung der Strahlung von zu einem Laserdiodenstack übereinander gestapelten Laserdiodenbarren,
mit einer Mehrzahl von in der x-Richtung nebeneinander und in der dazu senkrechten y-Richtung übereinander angeordneter Laserdioden,
sowie mit mehreren Mikrozylinderlinsenoptiken (2a, 2b, 2c) mit ausreichend großer Isoplanasie,
wobei jede Mikrozylinderlinsenoptik einem anderen, in x-Richtung nebeneinander angeordneten linearen Array von Laserdioden zugeordnet ist, und um die in z-Richtung stehende optische Achse des zugeordneten linearen Arrays von Laserdioden gekippt angeordnet ist, so dass die Milcrozylinderoptik die Ausgangsstrahlbündel der einzelnen Laserdioden des zugeordneten linearen Arrays von Laserdioden in der y-Richtung kollimiert und je nach x-Koordinate unterschiedlich stark ablenkt, wodurch die Ausgangsstrahlbündel bezüglich der y-Richtung getrennt werden,
wobei ferner den Mikrozylinderlinsenoptiken (2a, 2b, 2c) ein Direktionselement (3) nachgeordnet ist, das die Strahlenbündel (8) der in der x-Richtung nebeneinander angeordneten einzelnen Laserdioden in der x-Richtung mit jeweils unterschiedlichen Ablenkwinkeln derart umlenkt, dass die Schwerpunkte der einzelnen Strahlenbündel (8) in einem vorgegebenen Abstand in Bezug auf die x-Richtung zusammenfallen und die Abstrahlung jedes einzelnen linearen Laserdiodenarrays in der y-Richtung so umlenkt, dass die Bündelschwerpunkte übereinanderliegender Einzelemitter unterschiedlicher Barren in einem vorgegebenen Abstand in Bezug auf die y-Richtung zusammenfallen,
und wobei im Abstand hinter dem Direktionselement (3) ein Redirektionselement (5) angeordnet ist, das die unterschiedlichen durch das Direktionselement (3) eingeführten Ablenkwinkel der Strahlenbündel (8) in der xz-Ebene wieder kompensiert.

2. Anordnung nach Anspruch 1,
**dadurch gekennzeichnet,**
**dass** dem Redirektionselement (5) eine Abbildungsoptik (4, 6) zugeordnet ist, die die Strahlenbündel (8) aller in der x-Richtung nebeneinander liegenden Laserdioden in je einen gemeinsamen Strahlungsfleck abbildet, die in gespreizte Einzelfasern (7a, 7b, 7c) eines Faserbündels (7) eingekoppelt und so zu einem gemeinsamen Strahlungsfleck vereint werden.

3. Anordnung nach einem der Ansprüche 1 bis 2,
**dadurch gekennzeichnet,**
**dass** jede der Mikrozylinderlinsenoptiken (2a, 2b, 2c) eine gradientenoptische Mikrozylinderlinse GRIN, eine sphärische oder Asphären-Mikrozylinderlinse, eine Fresnellinse und/oder eine Kombination derselben aufweist.

4. Anordnung nach einem der Ansprüche 1 bis 3,
**dadurch gekennzeichnet,**
**dass** das Direktionselement (3) als Dublett, Bikonvex- oder Plankonvexlinse mit sphärischen oder asphärischen Oberflächen ausgebildet ist.

5. Anordnung nach Anspruch 1 oder 3 bis 4,
**dadurch gekennzeichnet,**
**dass** dem Direktionselement (3) ein optisches Element (9) zugeordnet ist, welches die Strahlung der in x-Richtung nebeneinander angeordneten Laserdioden gleichermaßen so ablenkt, dass die Strahlenbündel von in y-Richtung übereinander angeordneten Laserdioden in einem vorgegebenen Abstand in der x-Richtung voneinander separiert sind.

6. Anordnung nach Anspruch 5,
**dadurch gekennzeichnet,**
**dass** als ablenkendes Element (9) ein Array geblazter Gitter, ein Prismenstapel oder Spiegelstapel dient.

7. Anordnung nach Anspruch 5,
**dadurch gekennzeichnet,**
**dass** die Ablenkfunktion in der x-Richtung durch die Sektionierung des Direktionselements und anschließendes in der x-Richtung zueinander versetztes Zusammenfügen der Sektionen realisiert ist.

8. Anordnung nach einem der Ansprüche 1 bis 7,
**dadurch gekennzeichnet,**
**dass** als Redirektionselement (5) eine Array geblazter Gitter, ein Prismenstapel oder ein Spiegelstapel dient.

9. Anordnung nach einem der Ansprüche 5 bis 7
**dadurch gekennzeichnet,**
**dass** dem Redirektionselement (5) ein in der y-Richtung ablenkendes Element (10) zugeordnet ist, welches die Strahlenbündel (8) der einzelnen Barren (1a, 1b, 1c) in der y-Richtung so umlenkt, dass sie das Redirektionselement (5) parallel zur z-Achse verlassen.

10. Anordnung nach Anspruch 9,
**dadurch gekennzeichnet,**
**dass** als ablenkendes Element (10) ein Array geblazter Gitter, ein Prismenarray oder ein Spiegelarray dient.

11. Anordnung nach Anspruch 9,
**dadurch gekennzeichnet,**
**dass** sowohl die Funktion des Redirektionselements (5) als auch des ablenkenden Elements (10) durch ein diffraktives Element realisiert ist.

12. Anordnung nach einem der Ansprüche 1 bis 11,
**dadurch gekennzeichnet,**
**dass** dem Redirektionselement (5) eine Linse (4), die eine Kollimation der Einzelbündel (8) in der x-Richtung bewirkt, vorgeschaltet ist.

13. Anordnung nach Anspruch 12,
**dadurch gekennzeichnet,**
**dass** die dem Redirektionselement (5) vorgeschaltete Linse (4) als Dublett, Bikonvex- oder Plankonvexlinse mit sphärischen oder asphärischen Oberflächen ausgebildet ist.

14. Anordnung nach einem der Ansprüche 1 bis 13,
**dadurch gekennzeichnet,**
**dass** dem Redirektionselement (5) eine Fokussierlinse (6) nachgeordnet ist, die die Bündel (8) in einen oder mehrere Strahlungsflecke fokussiert.

15. Anordnung nach Anspruch 14,
**dadurch gekennzeichnet,**
**dass** die Fokussierlinse (6) als Achromat, Achromat und Meniskuslinse, Plankovexlinse, Plankovexlinse und Meniskuslinse oder Bikonvexlinse mit jeweils sphärischer oder asphärischer Profilform ausgebildet ist.

## Claims

1. An optical arrangement for symmetrizing the radiation of a plurality of laser diodes arranged in a fixed relationship alongside one another in the x-direction and above one another in the y-direction perpendicular thereto, whose output radiation in question is asymmetrical in relation to the y-direction and the x-direction, especially for symmetrizing the radiation from laser diode bars stacked over one another to a laser diode stack,
with a plurality of laser diodes arranged alongside one another in the x-direction and above one another in the y-direction perpendicular thereto,
as well as with a plurality of micro-cylinder lens optics (2a, 2b, 2c) with sufficiently great isoplanarity.
wherein each micro-cylinder lens optic is associated with a different linear array of laser diodes arranged alongside one another in the x-direction and is tilted about the optical axis running in the z-direction of the associated linear array of laser diodes, so that the micro-cylinder optic collimates in the y-direction the output bundles of rays of the individual laser diodes of the associated linear array of laser diodes and deflects them to different extents in dependence on the x-coordinate, whereby the output bundles of rays are separated relative to the y-direction,
wherein further a directing element (3) follows the micro-cylinder lens optics (2a, 2b, 2c) and so deflects the bundles of rays (8) of the individual laser diodes arranged alongside one another in the x-direction with different angles of deflection that the centroids of the individual bundles or rays (8) coincide at a predetermined distance relative to the x-direction and the radiation of each individual linear laser diode array is so deflected in the y-direction that the bundle centroids of individual emitters of different bars lying above one another coincide at a predetermined distance relative to the y-direction,
and wherein a redirecting element (5) is arranged spaced behind the directing element (3) and compensates again for different angles of deflection of the bundles of rays (8) introduced by the directing element (3).

2. An arrangement according to claim 1, **characterized in that** imaging optics (4, 6) are associated with the re-directing element (5) and image the bundles of rays (8) of all laser diodes lying alongside one another in the x-direction in a common radiation spot, which spots are coupled into spread individual fibres (7a, 7b, 7c) of a fibre bundle (7) and are thus combined to a single radiation spot.

3. An arrangement according to either claim 1 or 2, **characterized in that** each of the micro-cylinder lens optics (2a, 2b, 2c) comprises a gradient optical micro-cylinder lens GRIN, a spherical or aspherical micro-cylinder lens, a Fresnel lens and/or a combination thereof.

4. An arrangement according to any of claims 1 to 3, **characterized in that** the directing element (3) is formed as a doublet, a biconvex or a planoconvex lens with spherical or aspherical surfaces.

5. An arrangement according to claim 1 or 3 to 4, **characterized in that** an optical element (9) is associated with the directing element (3) which so deflects the radiation of the laser diodes arranged alongside one another in the x-direction that the bundles of rays from laser diodes arranged above one another in the y-direction are separated from one another by a predetermined distance in the x-direction.

6. An arrangement according to claim 5, **characterized in that** a blazed grating array, a prism stack or mirror stack serves as the deflecting element (9).

7. An arrangement according to claim 5, **characterized in that** the deflecting function in the x-direction is realised by the sectioning of the directing element and following joining together of the sections offset from one another in the x-direction.

8. An arrangement according to any of claims 1 to 7, **characterized in that** a blazed grating array, a prism stack or a mirror stack serves as the redirecting element (5).

9. An arrangement according to any of claims 5 to 7, **characterized in that** an element (10) deflecting in the y-direction is associated with the redirecting element (5) and so deflects the bundles of rays (8) of the individual bars (1a, 1b, 1c) in the y-direction that they leave the redirecting element (5) parallel to the z-axis.

10. An arrangement according to claim 9, **characterized in that** a blazed grating array, a prism stack or mirror stack serves as the deflecting element (10).

11. An arrangement according to claim 9, **characterized in that** the function of both the redirecting element (5) and the deflecting element (10) is realised by a diffractive element.

12. An arrangement according to any of claims 1 to 11, **characterized in that** a lens (4) is placed ahead of the redirecting element (5) and effects collimation of the individual bundles (8) in the x-direction.

13. An arrangement according to claim 12, **characterized in that** the lens (4) placed ahead of the redirecting element (5) is formed as a doublet, a biconvex or a planoconvex lens with spherical or aspherical surfaces..

14. An arrangement according to any of claims 1 to 13, **characterized in that** a focussing lens (6) is placed after the redirecting element (5) and focuses the bundles (8) in one or more radiation spots.

15. An arrangement according to claim 14, **characterized in that** the focussing lens (6) is formed as ab achromatic lens, achromatic lens and meniscus lens, planoconvex lens, planoconvex lens and meniscus lens or biconvex lens with a spherical or aspherical profile form in each case.

## Revendications

1. Dispositif optique pour rendre symétrique le rayonnement d'un ensemble de diodes lasers selon une répartition fixe, juxtaposées dans la direction x et dans la direction y perpendiculaire à la direction x, dont le rayonnement émis est asymétrique par rapport à la direction y et à la direction x, en particulier pour rendre symétrique le rayonnement d'une pile de diodes lasers, de barres de diodes lasers empilées, comprenant un ensemble de diodes lasers juxtaposées dans la direction x et superposées dans la direction y perpendiculaire à la direction précédente, ainsi que plusieurs optiques micro-cylindriques (2a, 2b, 2c) à isoplanasie suffisamment grande,
dans lequel
chaque optique micro-cylindrique est associée à un autre réseau de diodes lasers, linéaires, juxtaposées dans la direction x, et qui sont basculées autour de l'axe optique dans la direction (z), des réseaux linéaires associés des diodes lasers, de sorte que l'optique à micro-cylindres focalise les faisceaux de rayons de sortie des différentes diodes lasers des réseaux linéaires associés de diodes lasers dans la direction y et les dévie différemment suivant les coordonnées x, pour séparer ainsi le faisceau de rayons de sortie dans la direction y,
et, en outre, ou associe en aval aux optiques à micro-cylindres (2a, 2b, 2c), un élément de direction (3) qui dévie les faisceaux de rayons (8) des différentes diodes lasers juxtaposées dans la direction x, avec des angles de déviation différents dans la direction x, de façon que les centres de gravité des différents faisceaux de rayons (8) se regroupent à une distance prédéterminée par rapport à la direction x et que le rayonnement de sortie de chacun des réseaux de diodes lasers linéaires soit dévié dans la direction y pour que les centres de gravité des faisceaux des différents émetteurs superposés, de différentes barres se regroupent à une distance prédéterminée par rapport à la direction y, et
à une certaine distance derrière l'élément de direction (3), on a un élément de remise en direction (5) qui compense de nouveau l'angle de déviation des faisceaux de rayons (8) induit différemment par l'élément de direction (3), dans le plan xz.

2. Dispositif selon la revendication 1,
**caractérisé en ce qu'**
une optique image (4, 6) est associée à l'élément de remise en direction (5) pour former une image du faisceau de rayons (8) de toutes les diodes lasers juxtaposées dans la direction x, dans une tache de rayon, commune, couplée dans les différentes fibres écartées (7a, 7b, 7c) d'un faisceau de fibres (7) et les réunit dans une tache de rayonnement commune.

3. Dispositif selon l'une des revendications 1 et 2,
**caractérisé en ce que**
chacune des optiques à micro-cylindres (2a, 2b, 2c) comportent une lentille à micro-cylindres à gradient optique GRIN, une lentille à micro-cylindres sphériques ou a-sphériques, une lentille de Fresnel et/ou une combinaison de ces lentilles.

4. Dispositif selon l'une des revendications 1 à 3,
**caractérisé en ce que**
l'élément de direction (3) est un doublet, une lentille biconvexe ou une lentille convexe plane à surface sphérique ou a-sphérique.

5. Dispositif selon la revendication 1 ou les revendications 3 et 4,
**caractérisé en ce qu'**
on associe à l'élément directionnel (3) un élément optique (9) qui dévie de la même manière le rayonnement des diodes lasers juxtaposées dans la direction x, de façon que les faisceaux des rayons des diodes lasers superposées dans la direction y soient séparés les uns des autres à une distance prédéterminée dans la direction x.

6. Dispositif selon la revendication 5,
**caractérisé en ce que**
l'élément déflecteur (9) est un réseau à grilles éclatées, une pile de prismes ou une pile de miroirs.

7. Dispositif selon la revendication 5,
**caractérisé en ce que**
la fonction de déflection dans la direction x est assurée par le sectionnement de l'élément directionnel et l'assemblage consécutif des sections décalées dans la direction x.

8. Dispositif selon l'une des revendications 1 à 7,
**caractérisé en ce que**
l'élément de remise en direction (5) est un réseau de grilles éclatées, une pile de prismes ou une pile de miroirs.

9. Dispositif selon l'une des revendications 5 à 7,
**caractérisé en ce qu'**
un élément de déflection (10) déviant dans la direction y est associé à l'élément de remise en direction (5) qui dévie les faisceaux de rayons (8) des différentes barres (1a, 1b, 1c) dans la direction y pour que les rayons quittent l'élément de remise en direction (5) parallèlement à l'axe z.

10. Dispositif selon la revendication 9,
**caractérisé en ce que**
l'élément de déflection (10) est un réseau de grilles éclatées, un réseau de prismes ou un réseau de miroirs.

11. Dispositif selon la revendication 9,
**caractérisé en ce que**
à la fois la fonction de l'élément de remise en direction (5) et de l'élément déflecteur (10) est réalisé par un élément de diffraction.

12. Dispositif selon l'une des revendications 1 à 11,
**caractérisé en ce qu'**
une lentille (4), qui assure la colimation des différents faisceaux (8) dans la direction x, est prévue en amont de l'élément de remise en direction (5).

13. Dispositif selon la revendication 12,
**caractérisé en ce que**
la lentille (4) en amont de l'élément de remise en direction (5) est un doublet, une lentille biconvexe ou une lentille plan-convexe à surface sphérique ou asphérique.

14. Dispositif selon l'une des revendications 1 à 13,
**caractérisé en ce qu'**
une lentille de focalisation (6) est prévue en aval de l'élément de remise en direction (5) pour focaliser les faisceaux (8) sur une ou plusieurs taches focales.

15. Dispositif selon la revendication 14,
**caractérisé en ce que**
la lentille de focalisation (6) est une lentille achromatique, une lentille achromatique avec un ménisque, une lentille plan-convexe, une lentille plan-convexe et une lentille à ménisque ou une lentille biconvexe avec chaque fois une forme de profil sphérique ou a-sphérique.
